# EUROPEAN PATENT APPLICATION

(11) **EP 4 811 950 A1**
(43) Date of publication of application: **23.09.2026**
(21) Application number: 24891079.6
(22) Date of filing: 19.09.2024
(51) Int. Cl.: H05K 9/00, B32B 7/025, B32B 27/18

(54) **ELECTROMAGNETIC WAVE-SHIELDING MOLDED FILM**

(30) Priority: 17.11.2023 JP 2023195598; 13.06.2024 JP 2024095613
(71) Applicant: Toray Industries, Inc., Tokyo 103-8666 (JP)
(72) Inventor: KITAMURA, Yutaka, Otsu-shi, Shiga 520-2141 (JP); MORI, Kentaro, Otsu-shi, Shiga 520-2141 (JP)
(74) Representative: Mewburn Ellis LLP
(86) International application number: PCT/JP2024/033402
(87) International publication number: WO 2025/105037

(57) **Abstract**

The purpose of the present invention is to provide an electromagnetic wave-shielding molded film having excellent electromagnetic wave shielding properties, moldability, and electromagnetic wave shielding properties after molding. This electromagnetic wave-shielding molded film has at least a conductive layer on one surface of a substrate film, wherein: the conductive layer contains conductive particles A and a thermoplastic resin; the porosity of the conductive layer on a cut surface is 5-30%; and the aspect ratio of the conductive particles A is 5.0-20.0.

## Description

### TECHNICAL FIELD

The present invention relates to a molding film for electromagnetic wave shields.

### BACKGROUND ART

In recent years, as the loT society advances, there has been an increasing demand for instruments with high electromagnetic wave shielding performance in various fields such as mobile phones, electric appliances, and automotive parts. When resin is used to produce their housings, there are known methods useful for treating the resulting molded articles such as plating and electrically conductive coating. However, these conventional methods require environment countermeasures such as wastewater processing and post-treatment of solvents, and various attempts are being made aiming to make improvements in these aspects.

For example, Patent document 1 discloses a technique related to a molding film for in-mold transfer processing that has an electrically conductive layer containing metal, electrically conductive polymer resin, etc. In addition, Patent document 2 discloses a technique for in-mold transfer processing intended to mold a molding film that has an electrically conductive layer containing resin and electrically conductive fine particles.

### PRIOR ART DOCUMENTS

### PATENT DOCUMENTS

Patent document 1: Japanese Unexamined Patent Publication (Kokai) No. 2006-297642
Patent document 2: Japanese Unexamined Patent Publication (Kokai) No. 2021-192960

### SUMMARY OF INVENTION

### PROBLEMS TO BE SOLVED BY THE INVENTION

However, the technique described in Patent document 1 has disadvantage relating to applicability to molded products having difficult shapes because cracks and breakages can occur in the electrically conductive layer and base film in the case where the materials to be molded have complex shapes. On the other hand, although the technique described in Patent document 2 can allow the electrically conductive layer to conform to complex shapes of materials to be molded, it is disadvantageous due to poor electromagnetic wave shielding performance.

The main object of the present invention is to solve these problems with the conventional techniques and thereby make it possible to provide a molding film for electromagnetic wave shields that has high electromagnetic wave shielding capability and high moldability and maintains high electromagnetic wave shielding capability after being molded.

### MEANS OF SOLVING THE PROBLEMS

The inventors of the present invention have arrived at this invention after making intensive studies to solve the above problems and finding that the problems can be solved as described below. Specifically, described below is the molding film for electromagnetic wave shields according to a preferred embodiment of the present invention that has a configuration as described below.
(1) A molding film for electromagnetic wave shields comprising a base film and an electrically conductive layer disposed on at least one side thereof, wherein the electrically conductive layer contains electrically conductive particles A and a thermoplastic resin, the electrically conductive layer having a cross section with a void fraction of 5% or more and 30% or less, and the electrically conductive particles A having an aspect ratio of 5.0 or more and 20.0 or less.
(2) A molding film for electromagnetic wave shields as set forth in the paragraph (1), wherein the cross sections of the voids observed in the cross section of the electrically conductive layer have shapes with an aspect ratio of 1.0 or more and 20.0 or less.
(3) A molding film for electromagnetic wave shields as set forth in the paragraph (2), wherein the voids have an orientation angle of 0° or more and 45° or less.
(4) A molding film for electromagnetic wave shields as set forth in any one of the paragraphs (1) to (3), wherein the electrically conductive layer contains electrically conductive particles B having an aspect ratio of 1.0 or more and 2.0 or less.
(5) A molding film for electromagnetic wave shields as set forth in any one of the paragraphs (1) to (4), wherein the area of the electrically conductive particles accounts for 50% or more and 90% or less of the cross section of the electrically conductive layer while the area of the thermoplastic resin accounts for 5% or more and 45% or less of the cross section of the electrically conductive layer.
(6) A molding film for electromagnetic wave shields as set forth in any one of the paragraphs (1) to (5), wherein the electrically conductive particles A observed in the cross section of the electrically conductive layer have an orientation angle of 3° or more and 45° or less.
(7) A molding film for electromagnetic wave shields as set forth in any one of the paragraphs (1) to (6), wherein the thickness of the electrically conductive layer is 5 µm or more and 15 µm or less.
(8) A molding film for electromagnetic wave shields as set forth in any one of the paragraphs (1) to (7), wherein a release layer is present between the base film and the electrically conductive layer.

### PREFERRED EFFECTS OF THE INVENTION

The present invention can provide a molding film for electromagnetic wave shields that has high electromagnetic wave shielding capability and high moldability and maintains high electromagnetic wave shielding capability after being molded.

### Brief Description of Drawings

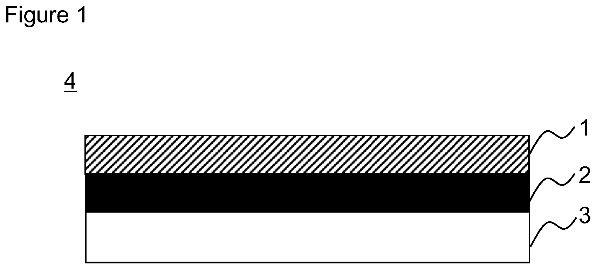

[Fig. 1] This is a schematic cross-sectional view of the molding film for electromagnetic wave shields according to an embodiment of the present invention.

### Description of Embodiments

The molding film for electromagnetic wave shields according to the present invention includes a base film and an electrically conductive layer disposed on at least one surface thereof, wherein the electrically conductive layer contains electrically conductive particles A and a thermoplastic resin, the electrically conductive layer having a cross section with a void fraction of 5% or more and 30% or less, and the electrically conductive particles A having an aspect ratio of 5 or more and 20 or less. Such a configuration allows the molding film for electromagnetic wave shields according to the present invention to exhibit high electromagnetic wave shielding capability and high moldability and maintain high electromagnetic wave shielding capability after being molded.

The molding film for electromagnetic wave shields according to the present invention will be described in more detail below. Here, as described above in Fig. 1, the molding film for electromagnetic wave shields 4 has an electrically conductive layer 1, a release layer 2, and a base film 3, which are located in this order.

### (Electrically conductive layer)

The electrically conductive layer used for the present invention includes electrically conductive particles A and a thermoplastic resin, wherein the electrically conductive layer has a cross section with a void fraction of 5% or more and 30% or less and wherein the electrically conductive particles A have an aspect ratio of 5 or more and 20 or less. Such a configuration allows the molding film for electromagnetic wave shields to exhibit high electromagnetic wave shielding capability and high moldability and maintain high electromagnetic wave shielding capability after being molded.

As the electrically conductive particles A to use for the present invention, it is preferable to employ particles that contain one or more substances selected from the group consisting of zero-valent carbon, silver, gold, copper, nickel, chromium, palladium, indium, aluminum, zinc, and platinum. Such a configuration allows the electrically conductive layer to have a lower resistivity, thereby serving to produce a molding film for electromagnetic wave shields that has high electromagnetic wave shielding capability. From the same point of view as described above, it is more preferable for the electrically conductive particles A to contain one or more substances selected from the group consisting of gold, silver, silver-plated copper powder, and alloys of silver and copper. It should be noted that the term "zero-valent" modifies not only carbon but also all of the metal elements listed above. Whether the electrically conductive particles A contain a zero-valent metal element or not can be determined by cutting the molding film for electromagnetic wave shields to prepare a cross-sectional specimen and subjecting it to energy dispersive X-ray spectroscopy mapping analysis (hereinafter referred to as EDX mapping analysis) to see if a zero-valent metal element is detected in a particle region. EDX mapping analysis can be performed, for example, by using a scanning electron microscope (XL30 SFEG, manufactured by FEI Company) equipped with an energy dispersive X-ray spectrometer (NEW XL30 132-2.5, manufactured by EDAX) under the conditions of an acceleration voltage of 20 kV and a magnification of 20,000x. Here, the cutting of the molding film for electromagnetic wave shields can be performed, for example, by using a Cross Section Polisher (registered trademark) SM-09010 (manufactured by JEOL). When using this device, a test sample is prepared by treating the film with argon gas for 10 hours at an acceleration voltage of 4 kV and a current of 70 µA. For carbon particles, furthermore, qualitative analysis is carried out first by examining a cross-sectional specimen prepared by the same procedure as described above and subjecting it to micro-Raman mapping analysis. For the micro-Raman mapping analysis, measurement can be performed, for example, by using a micro-laser Raman spectroscopy apparatus (LabRAM (registered trademark) HR Evolution, manufactured by Horiba Ltd.).

The electrically conductive particles A used for the present invention have an aspect ratio of 5.0 or more and 20.0 or less. If the electrically conductive particles A have an aspect ratio of 5.0 or more, overlapping of particles can be maintained in the electrically conductive layer in the molded film, thereby allowing the molded film to have high electromagnetic wave shielding capability after being molded. From the same point of view as described above, it is preferable for their aspect ratio to be 7.0 or more. On the other hand, if the electrically conductive particles A have an aspect ratio of 20.0 or less, it allows the particles in the electrically conductive layer to have an improved dispersibility and accordingly allows the molding film for electromagnetic wave shields to have high moldability and maintain high electromagnetic wave shielding capability after being molded. From the same point of view, it is preferably 15.0 or less. The aspect ratio of the electrically conductive particles A can be calculated as the ratio of the average long diameter to the average short diameter of the electrically conductive particles A. To determine the ratio of [the average long diameter / the average short diameter] of the electrically conductive particles A, a good method, for example, is to prepare a cross-sectional specimen by cutting the molding film for electromagnetic wave shields and observing it under a scanning electron microscope (XL30 SFEG, manufactured by FEI Company) at an acceleration voltage of 20 kV and a magnification of 100,000x. From the image obtained, 50 particles are selected and each of them is approximated as an ellipse. The aspect ratio is calculated using the average of their maximum lengths and that of their minimum lengths to represent their long diameter and short diameter, respectively. Here, for the preparation of a test sample, the cutting of the molding film for electromagnetic wave shields can also be carried out, for example, by using a manual type rotary microtome (HistoCore BIOCUT (registered trademark) R, manufactured by Leica Microsystems).

It is preferable that the electrically conductive particles A used for the present invention have an orientation angle of 3° or more and 45° or less. If the orientation angle is 45° or less, it works to increase the number of contact points among the electrically conductive particles A in the electrically conductive layer and accordingly decrease the resistance value of the electrically conductive layer, thereby allowing the molding film for electromagnetic wave shields to have high electromagnetic wave shielding capability. From the same point of view, it is more preferable for the orientation angle to be 33° or less. On the other hand, if the orientation angle is 3° or more, contact points among the electrically conductive particles A can be maintained even while the electrically conductive particles A are pulled into void portions during the molding process in which the electrically conductive layer is stretched. Therefore, it allows the molding film for electromagnetic wave shields to maintain high electromagnetic wave shielding capability after being molded. From the same point of view, it is more preferable for the orientation angle to be 5° or more. The orientation angle of the electrically conductive particles A can be decreased by increasing the area and the aspect ratio of the electrically conductive particles A in the electrically conductive layer. On the other hand, the orientation angle of the electrically conductive particles A can be decreased by increasing the void fraction in the electrically conductive layer. For the present invention, the orientation angle of the electrically conductive particles A refers to the average angle of angle of the length direction of the electrically conductive layer to the length direction of the electrically conductive particles A in a cross section of the electrically conductive layer. An orientation angle of 0° indicates that it is parallel to the length direction of the electrically conductive layer while an orientation angle of 90° indicates that it is perpendicular to the length direction of the electrically conductive layer.

For the present invention, preferred examples of the thermoplastic resin include polyester resins, polyurethane resins, (meth)acrylic resins, polyolefin resins, ethylene-vinyl acetate copolymer resins, polyamide resins, chloroprene resins, aramid resins, acrylic urethane copolymer resins, and polyester urethane copolymer resins, which may be used separately or in combination. Such a configuration serves to ensure an increased dispersibility of the electrically conductive particles A and the electrically conductive particles B, which will be described later, present in the electrically conductive layer, as well as an increased moldability and flexibility of the entire electrically conductive layer, thereby allowing the molding film for electromagnetic wave shields to have high electromagnetic wave shielding capability and moldability and maintains high electromagnetic wave shielding capability after being molded. From the same point of view as described above, it is more preferable to use polyester resins, polyurethane resins, or polyester urethane copolymer resins.

Good methods for the qualitative and quantitative analysis of the thermoplastic resin to use for the present invention include, for example, scraping off only the electrically conductive layer from the molding film for electromagnetic wave shields and then freeze-drying the electrically conductive layer sample obtained, followed by subjecting the recovered dried solid material to qualitative and quantitative analysis by means of a gas chromatography-mass spectrometry apparatus equipped with a purge and trap sampler (thermal desorption device) (P&T-GC/MS).

The void fraction in a cross section of the electrically conductive layer used for the present invention is 5% or more and 30% or less. If the void fraction is 5% or more, it serves to maintain gaps into which electrically conductive particles can enter during the molding process that involves the stretching of the electrically conductive layer, thereby preventing the generation of cracks in the electrically conductive layer. Accordingly, it helps to allow the molding film for electromagnetic wave shields to have high moldability and maintain high electromagnetic wave shielding capability after being molded. From the same point of view as described above, it is preferable for the void fraction to be 7% or more. If the void fraction is 30% or less, on the other hand, it serves to ensure required overlapping among the electrically conductive particles before start of the molding process, thereby helping to allowing the molding film for electromagnetic wave shields to have high electromagnetic wave shielding capability. From the same point of view as described above, it is preferable for the void fraction to be 15% or less.

For example, in a good method for ensuring a void fraction of 5% or more and 30% or less for the present invention, the lamination of an electrically conductive layer onto a base film is carried out by using an electrically conductive layer coating composition that includes an organic solvent for mixing in combination with an organic solvent for dilution having a relative evaporation rate at least five times faster than the former. If this method is adopted, the difference in relative evaporation rate between the organic solvent for mixing and the organic solvent for dilution works to form voids in the electrically conductive layer during the heat treatment that is performed after applying the electrically conductive layer coating composition to the base film. The relative evaporation rate based on n-butyl acetate as reference can be determined in terms of the evaporation rate measured in accordance with ASTMD 3539-87 (2004). Specifically, it is defined as the relative value of the evaporation rate that is determined based on the time required for evaporating a 90 mass% amount of n-butyl acetate in a dry air atmosphere.

Preferred examples of the organic solvent for mixing include ethylene glycol monoethyl ether, ethylene glycol monoisopropyl ether, ethylene glycol monobutyl ether, diethylene glycol dimethyl ether, diethylene glycol diethyl ether, diethylene glycol monoethyl ether, diethylene glycol monobutyl ether, propylene glycol monomethyl ether, propylene glycol monoethyl ether, diethylene glycol monomethyl ether, diethylene glycol monoethyl ether, diethylene glycol monobutyl ether, diethylene glycol monoethyl ether acetate, diethylene glycol monobutyl ether acetate, butyl carbitol, hexyl carbitol, diethylene glycol monoethyl ether acetate, diethylene glycol monobutyl ether acetate, 1-methoxy-2-propanol, 1-ethoxy-2-propanol, ethylene glycol mono-n-propyl ether, diacetone alcohol, tetrahydrofurfuryl alcohol, and propylene glycol monomethyl ether acetate, which are preferably used separately or in combination. The use of these organic solvents serves to ensure a high solubility of the thermoplastic resin and a high processability in the step of mixing an electrically conductive resin and a thermoplastic resin. Furthermore, since they are low in the relative evaporation rate, they help to form voids during the implementation of the heat treatment of the electrically conductive layer coating composition.

Here, preferred examples of the organic solvent for dilution include ethyl methyl ketone, methyl isobutyl ketone, butyl acetate, ethyl acetate, methanol, isopropanol, cyclohexanone, and toluene, which are preferably used separately or in combination. The use of these organic solvents serves to decrease the viscosity of the electrically conductive layer coating composition and thereby ensure high coatability when applying the electrically conductive layer coating composition to the base film. Furthermore, they are high in the relative evaporation rate, and it helps to allow the molding film for electromagnetic wave shields to exhibit high productivity.

It is preferable that the cross-sectional shapes of the voids observed in a cross section of the electrically conductive layer used for the present invention have an aspect ratio of 1.0 or more and 20.0 or less. If the cross-sectional shapes of the voids have an aspect ratio of 1.0 or more, it serves to maintain gaps into which electrically conductive particles can enter during the molding process that involves the stretching of the electrically conductive layer, thereby preventing the generation of cracks in the electrically conductive layer. Accordingly, it allows the molding film for electromagnetic wave shields to have high moldability and maintain high electromagnetic wave shielding capability after being molded. From the same point of view as described above, it is more preferable for the cross-sectional shapes of the voids to have an aspect ratio of 3.0 or more. If the cross-sectional shapes of the voids have an aspect ratio of 2.0 or less, on the other hand, it serves to ensure required overlapping among the electrically conductive particles before start of the molding process, thereby helping to allow the molding film for electromagnetic wave shields to have high electromagnetic wave shielding capability. From the same point of view as described above, it is preferable for the cross-sectional shapes of the voids to have an aspect ratio of 15.0 or less. The aspect ratio of the cross-sectional shapes of the voids can be improved by increasing the area of the electrically conductive particles in the electrically conductive layer and increasing the aspect ratio of the electrically conductive particles. On the other hand, the aspect ratio of the cross-sectional shapes of the voids can be decreased by increasing the void fraction in the electrically conductive layer. For the present invention, the aspect ratio of the cross-sectional shapes of the voids can be calculated as the ratio of the average long diameter to the average short diameter of the voids. To calculate the ratio of the average long diameter to the average short diameter of the voids, the same calculation method as used for the electrically conductive particles A can be used.

For the present invention, it is preferable for the voids to have an orientation angle of 0° or more and 45° or less. If the orientation angle of the voids is 45° or less, it ensures an increased number of contact points among the electrically conductive particles A in the electrically conductive layer to cause a decrease in the resistance value of the electrically conductive layer, thereby allowing the molding film for electromagnetic wave shields to have high electromagnetic wave shielding capability. From the same point of view as described above, it is more preferable for the voids to have an orientation angle of 33° or less. On the other hand, if the orientation angle of the voids is 0° or more, contact points among the electrically conductive particles A can be maintained even while the electrically conductive particles A are pulled into void portions during the molding process that involves the stretching of the electrically conductive layer. Therefore, it allows the molding film for electromagnetic wave shields to maintain high electromagnetic wave shielding capability after being molded. From the same point of view as described above, it is more preferable for the voids to have an orientation angle of 5° or more. The orientation angle of the voids can be decreased by increasing the area and the aspect ratio of the electrically conductive particles in the electrically conductive layer. On the other hand, the orientation angle of the voids can be decreased by increasing the void fraction in the electrically conductive layer. For the present invention, the orientation angle of the voids refers to the average angle of the length direction of the electrically conductive layer to the length direction of the voids in a cross section of the electrically conductive layer. If the orientation angle of the voids is 0°, it indicates that their length direction is parallel to the length direction of the electrically conductive layer while if the orientation angle of the voids is 90°, it indicates that their length direction is perpendicular to the length direction of the electrically conductive layer.

The void fraction of the electrically conductive layer can be measured, for example, by cutting a sample of the molding film for electromagnetic wave shields perpendicularly to the thickness using a manual type rotary microtome (HistoCore BIOCUT (registered trademark) R, manufactured by Leica Microsystems) to prepare a cross-sectional specimen of the molding film for electromagnetic wave shields and observing the cross section of the electrically conductive layer using a scanning electron microscope (XL30 SFEG, manufactured by FEI Company) at an accelerating voltage of 20 kV and an observation magnification of 100,000x. The area of void portions is calculated by subtracting the area of non-open portions from the area of the entire cross section observed in the photograph, and the void fraction can be calculated as the area ratio of the void portions to the entire area.

It is preferable for the electrically conductive layer used for the present invention to contain electrically conductive particles B that has an aspect ratio of 1.0 or more and 2.0 or less. If the electrically conductive layer includes electrically conductive particles B that have an aspect ratio of 1.0 or more and 2.0 or less, in addition to the electrically conductive particles A, it enables the closest packing of electrically conductive particles in the electrically conductive layer and serves to maintain contact points among the electrically conductive particles A and the electrically conductive particles B even while these electrically conductive particles are pulled into void portions during the molding process that involves the stretching of the electrically conductive layer. As a result, the overlapping among particles in the electrically conductive layer existing before the molding process can be maintained after the molding process, thereby allowing the molding film for electromagnetic wave shields to have high electromagnetic wave shielding capability and maintain high electromagnetic wave shielding capability after being molded. The aspect ratio of the electrically conductive particles B used for the present invention can be calculated by the same method as used for the electrically conductive particles A. As the electrically conductive particles B to use for the present invention, it is preferable to employ particles including one or more substances selected from the group consisting of zero-valent carbon, silver, gold, copper, nickel, chromium, palladium, indium, aluminum, zinc, and platinum. Such a configuration allows the electrically conductive layer to have a lower resistivity, thereby allowing the molding film for electromagnetic wave shields to have high electromagnetic wave shielding capability. From the same point of view as described above, it is more preferable that the electrically conductive particles B include one or more substances selected from the group consisting of gold, silver, silver-plated copper powder, and alloys of silver and copper.

The area of electrically conductive particles preferably accounts for 50% or more and 90% or less of a cross section of the electrically conductive layer used for the present invention, and the area of the thermoplastic resin preferably accounts for 5% or more and 45% or less of a cross section of the electrically conductive layer. The electrically conductive particles referred to herein mean the electrically conductive particles A used for the present invention and the electrically conductive particles B used for the present invention. If the electrically conductive particles account for an area proportion of 50% or more, it allows the electrically conductive particles to account for an increased content in the electrically conductive layer. Accordingly, it allows the molding film for electromagnetic wave shields to have high electromagnetic wave shielding capability and maintain high electromagnetic wave shielding capability after being molded. From the same point of view, it is more preferable for the proportion to be 75% or more. On the other hand, if the electrically conductive particles account for an area proportion of 90% or less, it allows the resin to account for an increased content in the electrically conductive layer, and accordingly, it allows the molding film for electromagnetic wave shields to have high moldability. From the same point of view, it is more preferable for the proportion to be 85% or less. From the same point of view as described above, if the thermoplastic resin accounts for an area proportion of 45% or less, it allows the electrically conductive particles to account for an increased proportion relative to all components that constitute the electrically conductive layer. Accordingly, it allows the molding film for electromagnetic wave shields to have high electromagnetic wave shielding capability and maintain high electromagnetic wave shielding capability after being molded. From the same point of view as described above, it is more preferable for the proportion to be 25% or less. On the other hand, if the thermoplastic resin accounts for an area proportion of 5% or more, it serves to ensure an increased dispersibility of the electrically conductive particles in the electrically conductive layer and also ensure an increased moldability and flexibility of the entire electrically conductive layer, thereby allowing the molding film for electromagnetic wave shields to have high moldability. From the same point of view as described above, it is more preferable for the proportion to be 7% or more. Here, it should be noted that the area proportion of the electrically conductive particles in a cross section of the electrically conductive layer is defined as the proportion of the total area of the electrically conductive particles seen in the observed image to the total area of the cross section in the observed image of the electrically conductive layer. It should also be noted that the area proportion of the thermoplastic resin in a cross section of the electrically conductive layer is defined as the proportion of the total area of the thermoplastic resin seen in the observed image to the total area of the cross section in the observed image of the electrically conductive layer.

For the present invention, it is preferable for the electrically conductive layer to have a thickness of 5 µm or more and 15 µm or less. If the thickness of the electrically conductive layer is 15 µm or less, it ensures stable heating of the electrically conductive layer during the molding process and this serves to reduce the in-plane variation in the electrically conductive layer, thereby allowing the molding film for electromagnetic wave shields to maintain high electromagnetic wave shielding capability after being molded. From the same point of view, it is more preferable for the electrically conductive layer to have a thickness be 12 µm or less. On the other hand, if the thickness of the electrically conductive layer is 5 µm or more, it causes an increase in the content of particles in the electrically conductive layer and leads to a decrease in the resistivity of the electrically conductive layer, and accordingly, it ensures a sufficiently high electrical conductivity and electromagnetic wave shielding capability. This allows the molding film for electromagnetic wave shields to have high electromagnetic wave shielding capability and maintain high electromagnetic wave shielding capability after being molded. From the same point of view, it is more preferable for the electrically conductive layer to have a thickness of 7 µm or more.

Here, good methods for qualitative and quantitative analysis of a thermoplastic resin include, for example, scraping off only the electrically conductive layer from the molding film for electromagnetic wave shields and then freeze-drying the electrically conductive layer sample obtained, followed by subjecting the recovered dried solid material to qualitative and quantitative analysis by means of a gas chromatography-mass spectrometry apparatus equipped with a purge and trap sampler (thermal desorption device) (P&T-GC/MS).

### (Base film)

Due to their high dimensional stability, durability, capability to realize improved productivity, and excellent processability during the lamination and molding processes of the release layer and the electrically conductive layer, it is preferable that base film to use for the present invention include one or more selected from the group consisting of polyester resins (such as polyethylene terephthalate, polybutylene terephthalate, polyethylene naphthalate, and the like), polymethyl methacrylate resins, acrylic resins, polycarbonate resins, polyethylene resins, polypropylene resins, polystyrene resins, fluororesins, triacetyl cellulose resins, polyvinyl alcohol resins, polyvinyl chloride resins, polyvinylidene chloride resins, ethylene-vinyl acetate copolymer resins, polyvinyl butyral resins, metal ion-crosslinked ethylene-methacrylic acid copolymer resins, polyurethane resins, and cyclic olefin resins. From the same point of view as described above, it is preferable to use polyester resins and particularly preferable to use polybutylene terephthalate.

### (Release layer)

The molding film for electromagnetic wave shields according to the present invention is suitably used in an process that includes a step of placing a film, such as for in-mold molding, in a mold and a subsequent step of injecting a resin and/or a resin precursor, and therefore, it is desirable to add a release layer positioned between the base film and the electrically conductive layer used for the present invention.

There are no particular limitations on the release layer to use for the present invention as long as it does not impair the preferred effects of the present invention, but good materials therefor include, for example, alkyd based resins, polyolefin based resins, resins containing long chain alkyl groups, fluororesins, silicone based resins, and mixtures or copolymers of organic resins and silicone based resins. Among these, silicone resins are preferred because their releasability can be adjusted easily.

There are no particular limitations on the method to use for laying a release layer on a base film, but it is preferable to form a release layer by an appropriate coating method such as the dip coating method, roller coating method, wire bar coating method, gravure coating method, and die coating method (U.S. Pat. No. 2,681,294), of which the use of the gravure coating method or the die coating method is more preferable from the viewpoint of processability.

### Examples

The present invention will be illustrated below in more detail with reference to examples, although it should not be construed that the present invention is limited thereto.

Fist, the measurement methods and evaluation methods used in the examples are described below.

### (1) Thickness of electrically conductive layer

To measure the thickness (µm) of an electrically conductive layer, a cross-sectional specimen of the molding film for electromagnetic wave shields was prepared first by cutting the molding film for electromagnetic wave shields perpendicularly to the thickness using a manual type rotary microtome (HistoCore BIOCUT (registered trademark) R, manufactured by Leica Microsystems). Then, in order to examine the cross section of the molding film for electromagnetic wave shields, the cross section of the electrically conductive layer was observed using a scanning electron microscope (XL30 SFEG, manufactured by FEI Company) at an accelerating voltage of 20 kV and an observation magnification of 100,000x. The thickness was measured at five randomly selected positions in the cross-sectional photograph and the average of the measurements taken was calculated and adopted.

### (2) Aspect ratio of cross-sectional shape of electrically conductive particles A, electrically conductive particles B, and voids

In performing the procedure described in the paragraph (1), 50 of the electrically conductive particles and 50 of the voids were extracted from the resulting scanning electron microscope image and each of them was approximated as an ellipse, followed by calculating the aspect ratio of the cross-sectional shape of the electrically conductive particles A, electrically conductive particles B, and voids, wherein the average of their maximum lengths and the average of their minimum lengths were used as their long diameter and short diameter, respectively. Next, for the electrically conductive particles A and the electrically conductive particles B, histograms were created with intervals of 0.1 using the aspect ratios obtained above, and the peak value was calculated to represent the aspect ratio of the electrically conductive particles A. In the case where two peaks were found, the smaller peak value was adopted to represent the aspect ratio of the electrically conductive particles B whereas the larger peak value was adopted to represent the aspect ratio of the electrically conductive particles A.

### (3) Orientation angle of electrically conductive particles A and voids

In performing the procedure described in the paragraph (1), 20 of the electrically conductive particles A and 20 of the voids were extracted from the resulting scanning electron microscope image. For each of them, the orientation angle of the length direction of the electrically conductive layer to the length direction of the electrically conductive particle A or void was calculated. Then, histograms were created with intervals of 1° using the orientation angles obtained above, and the peak values were calculated to represent the orientation angles of the electrically conductive particles A and the voids.

### (4) Void fraction and area proportions of electrically conductive particles A, electrically conductive particles B, and thermoplastic resin

In performing the procedure described in the paragraph (1), the scanning electron microscope images obtained above was cropped in such a manner that the electrically conductive particles A, electrically conductive particles B, and thermoplastic resin remained, and subjected to image analysis using HALCON (registered trademark) Ver. 10.0, manufactured by MVTec, to identify the void regions, followed by calculating the ratio of the total area of the void regions to the total area of the image, which was adopted as the void fraction. The area proportions of the electrically conductive particles A, electrically conductive particles B, and thermoplastic resin were also calculated by the same procedure as used for the void fraction.

### (5) Electromagnetic wave shielding capability of molding film for electromagnetic wave shields

A sample with a size of 120 mm × 120 mm was cut out of the molding film for electromagnetic wave shields, and measurement was carried out by the KEC method (electric field), followed by determining the electromagnetic wave shielding effect (dB) at a frequency of 300 MHz using a spectrum analyzer. In the results obtained, a larger electromagnetic wave shielding effect indicates a higher electromagnetic wave shielding capability of the molding film for electromagnetic wave shields.

### (6) Electromagnetic wave shielding effect of molding film for electromagnetic wave shields stretched at ratio of 1.6 lengthwise and 1.6 crosswise

The molding film for electromagnetic wave shields was cut to a size of 120 mm × 120 mm, and this piece of the molding film for electromagnetic wave shields was subjected to simultaneous biaxial stretching at a ratio of 1.6 lengthwise and 1.6 crosswise using a Labostretcher KARO 5.0, manufactured by Bruckner, to prepare a test sample. It was examined by the KEC method (electric field) and its electromagnetic wave shielding effect (dB) at a frequency of 1 GHz was measured using a spectrum analyzer. The measurement obtained was adopted to represent its electromagnetic wave shielding effect at a frequency of 1 GHz. A larger electromagnetic wave shielding effect indicates a higher electromagnetic wave shielding capability.

### (7) Moldability of molding film for electromagnetic wave shields

In performing the procedure described in the paragraph (6), a test sample was subjected to simultaneous biaxial stretching at a ratio of 1.6 lengthwise and 1.6 crosswise, and the simultaneously biaxially stretched test sample was observed visually, followed by performing its evaluation according to the criteria described below.
A: The electrically conductive layer is uniformly stretched relative to the base film, indicating a favorable result.
B: The electrically conductive layer is stretched relative to the base film, but the electrically conductive layer partly suffers from cracking. This is practically acceptable.
C: Cracks are seen over the entire electrically conductive layer. This is practically unacceptable.

The materials used were as listed below.

(Electrically conductive particles a)
   Silver particles (AgC-2011, manufactured by Fukuda Metal Foil & Powder Co., Ltd., average particle diameter 2.6 µm, flake-shaped)
(Electrically conductive particles b)
   Silver particles (AgC-B, manufactured by Fukuda Metal Foil & Powder Co., Ltd., average particle diameter 4.0 µm, flake-shaped)
(Electrically conductive particles c)
   Silver particles (AgG-204B, manufactured by Fukuda Metal Foil & Powder Co., Ltd., average particle diameter 7.2 µm, flake-shaped)
(Electrically conductive particles d)
   Silver particles (AG-2-1C, manufactured by Dowa Electronics Materials Co., Ltd., average particle diameter 0.8 µm, spherical)
(Electrically conductive particles e)
   Silver particles (AgC-222, manufactured by Fukuda Metal Foil & Powder Co., Ltd., average particle diameter 5.0 µm, kidney-shaped)
(Electrically conductive particles f)
   Silver particles (Ag-XF, manufactured by Fukuda Metal Foil & Powder Co., Ltd., average particle diameter 5.0 µm, flake-shaped)
(Electrically conductive particles g)
   Silver particles (AgC-251, manufactured by Fukuda Metal Foil & Powder Co., Ltd., average particle diameter 3.0 µm, kidney-shaped)
(Electrically conductive particles h)
   Silver particles (AgC-156, manufactured by Fukuda Metal Foil & Powder Co., Ltd., average particle diameter 1.5 µm, spherical)
(Thermoplastic resin)
   Urethane modified polyester resin (VYLON (registered trademark) UR-4800, manufactured by Toyobo Co., Ltd.), glass transition temperature 106°C, weight average molecular weight 25,000)
(Organic solvent a)
   Diethylene glycol monoethyl ether acetate (relative evaporation rate 0.2)
(Organic solvent b)
   Ethyl methyl ketone (relative evaporation rate 3.7)

### [Example 1]

### <Moldability of molding film for electromagnetic wave shields>

An electrically conductive layer coating composition for forming an electrically conductive layer was prepared using the components shown in Table 1. The components were dispersed or dissolved in diethylene glycol monoethyl ether acetate, used as organic solvent for mixing. The resulting liquid was kneaded in a three-roll mill and then it was mixed and dispersed in ethyl methyl ketone, used as organic solvent for dilution, in Homodisper (manufactured by PRIMIX Corporation), thereby providing an electrically conductive layer coating composition having a solid content of 30.0 mass%.

A polybutylene terephthalate film with a thickness of 50 µm (ESRM, manufactured by Okura Industrial Co., Ltd.), used as base film, was coated by the gravure coating method with a coating composition prepared by dissolving an alkyd modified silicone resin (X-62-900B, manufactured by Shin-Etsu Chemical Co., Ltd.) in methyl ethyl ketone, followed by mixing and dispersing in Homodisper (manufactured by PRIMIX Corporation). The coating was dried at 120 °C to provide a release layer laminated base film having a release layer with a thickness of 0.05 µm.

An electrically conductive layer coating composition was spread on the aforementioned release layer laminated base film by the gravure coating method, dried at 120°C, and solidified to lay an electrically conductive layer with a thickness of 10 µm, thereby providing a molding film for electromagnetic wave shields, which was then wound into a roll.

### [Examples 2 to 10 and Comparative examples 1 to 4]

Except for using the electrically conductive particles, organic solvent for mixing, and organic solvent for dilution shown in Tables 1 to 3, the same procedure as in Example 1 was carried out to prepare molding films for electromagnetic wave shields.

The molding films for electromagnetic wave shields prepared in Examples 1 to 10 were each good enough to serve as a molding film for electromagnetic wave shields that has high electromagnetic wave shielding capability and high moldability and maintain high electromagnetic wave shielding capability after being molded.

Compared to these, the molding films for electromagnetic wave shields prepared in Comparative example 1 and Comparative example 4 were both inferior to the molding films for electromagnetic wave shields prepared in Examples in terms of moldability and electromagnetic wave shielding capability after being molded.

Furthermore, the molding film for electromagnetic wave shields prepared in Comparative example 2 was inferior to the molding films for electromagnetic wave shields prepared in Examples in terms of initial electromagnetic wave shielding capability and electromagnetic wave shielding capability after being molded.

In addition, the molding films for electromagnetic wave shields prepared in Comparative example 3 was inferior to the molding films for electromagnetic wave shields prepared in Examples in terms of electromagnetic wave shielding capability after being molded.

### [Table 1]

**[Table 1]**

| | | | | Example 1 | Example 2 | Example 3 | Example 4 | Example 5 |
|---|---|---|---|---|---|---|---|---|
| components of electrically conductive layer coating composition | electrically conductive particles (mass%) | | a | 26 | 21 | 26 | 26 | - |
| | | | b | - | - | - | - | 26 |
| | | | c | - | - | - | - | - |
| | | | d | - | 5 | - | - | - |
| | | | e | - | - | - | - | - |
| | | | f | - | - | - | - | - |
| | | | g | - | - | - | - | - |
| | | | h | - | - | - | - | - |
| | thermoplastic resin (mass%) | | | 4 | 4 | 4 | 4 | 4 |
| | organic solvent for mixing (mass%) | | | 7 | 7 | 4 | 17 | 7 |
| | organic solvent for dilution (mass%) | | | 63 | 63 | 66 | 53 | 63 |
| electrically conductive layer | electrically conductive particles A | area (%) | | 68 | 55 | 70 | 57 | 68 |
| | | aspect ratio | | 8.0 | 8.0 | 8.0 | 8.0 | 60 |
| | | orientation angle (°) | | 30 | 10 | 30 | 40 | 35 |
| | electrically conductive particles B | area (%) | | - | 13 | - | - | - |
| | | aspect ratio | | - | 1.0 | - | - | - |
| | electrically conductive particles | area (%) | | 68 | 68 | 70 | 57 | 68 |
| | thermoplastic resin | area (%) | | 22 | 22 | 24 | 18 | 22 |
| | void | void fraction (%) | | 10 | 10 | 6 | 25 | 10 |
| | | aspect ratio | | 8.0 | 10.0 | 21.0 | 6.0 | 2.0 |
| | | orientation angle (°) | | 30 | 15 | 42 | 10 | 6 |
| | thickness (µm) | | | 10 | 10 | 10 | 10 | 10 |
| electromagnetic wave shielding capability of molding film for electromagnetic wave shields (dB) | | | | 55 | 60 | 55 | 30 | 55 |
| electromagnetic wave shielding capability of molding film for electromagnetic wave shields stretched at ratio of 1.6 lengthwise and 1.6 crosswise | | | | 30 | 40 | 20 | 25 | 20 |
| moldability of molding film for electromagnetic wave shields | | | | A | A | B | A | A |

### [Table 2]

**[Table 2]**

| | | | | Example 6 | Example 7 | Example 8 | Example 9 | Example 10 |
|---|---|---|---|---|---|---|---|---|
| components of electrically conductive layer coating composition | electrically conductive particles (mass%) | | a | - | 21 | 21 | 10 | 29 |
| | | | b | - | - | - | - | - |
| | | | c | 26 | - | - | - | - |
| | | | d | - | - | - | - | - |
| | | | e | - | - | - | - | - |
| | | | f | - | - | - | - | - |
| | | | g | - | 5 | - | - | - |
| | | | h | - | - | 5 | - | - |
| | thermoplastic resin (mass%) | | | 4 | 4 | 4 | 20 | 1 |
| | organic solvent for mixing (mass%) | | | 7 | 7 | 7 | 7 | 7 |
| | organic solvent for dilution (mass%) | | | 63 | 63 | 63 | 63 | 63 |
| electrically conductive layer | electrically conductive particles A | area (%) | | 68 | 55 | 55 | 48 | 91 |
| | | aspect ratio | | 15.0 | 8.0 | 8.0 | 8.0 | 8.0 |
| | | orientation angle (°) | | 15 | 10 | 6 | 2 | 47 |
| | electrically conductive particles B | area (%) | | | 13 | 13 | | |
| | | aspect ratio | | - | 2.2 | 1.2 | - | - |
| | electrically conductive particles | area (%) | | 68 | 68 | 68 | 48 | 91 |
| | thermoplastic resin | area (%) | | 22 | 22 | 22 | 42 | 4 |
| | void | void fraction (%) | | 10 | 10 | 10 | 10 | 5 |
| | | aspect ratio | | 22.0 | 16.0 | 9.0 | 2.0 | 22.0 |
| | | orientation angle (°) | | 46 | 25 | 7 | 3 | 46 |
| | thickness (µm) | | | 10 | 10 | 10 | 10 | 10 |
| electromagnetic wave shielding capability of molding film for electromagnetic wave shields (dB) | | | | 55 | 60 | 62 | 20 | 65 |
| electromagnetic wave shielding capability of molding film for electromagnetic wave shields stretched at ratio of 1.6 lengthwise and 1.6 crosswise | | | | 20 | 30 | 58 | 20 | 20 |
| moldability of molding film for electromagnetic wave shields | | | | B | A | A | A | B |

### [Table 3]

**[Table 3]**

| | | | | Comparative example 1 | Comparative example 2 | Comparative example 3 | Comparative example 4 |
|---|---|---|---|---|---|---|---|
| components of electrically conductive layer coating composition | electrically conductive particles (mass%) | | a | 26 | 26 | - | - |
| | | | b | - | - | - | - |
| | | | c | - | - | - | - |
| | | | d | - | - | - | - |
| | | | e | - | - | 26 | - |
| | | | f | - | - | - | 26 |
| | | | g | - | - | - | - |
| | | | h | - | - | - | - |
| | thermoplastic resin (mass%) | | | 4 | 4 | 4 | 4 |
| | organic solvent for mixing (mass%) | | | 2 | 22 | 7 | 7 |
| | organic solvent for dilution (mass%) | | | 68 | 48 | 63 | 63 |
| electrically conductive layer | electrically conductive particles A | area (%) | | 73 | 49 | 68 | 68 |
| | | aspect ratio | | 8.0 | 8.0 | 3.5 | 25.0 |
| | | orientation angle (°) | | 30 | 50 | 30 | 30 |
| | electrically conductive particles B | area (%) | | - | - | - | - |
| | | aspect ratio | | - | - | - | - |
| | electrically conductive particles | area (%) | | 73 | 49 | 68 | 68 |
| | thermoplastic resin | area (%) | | 25 | 16 | 22 | 22 |
| | void | void fraction (%) | | 2 | 35 | 10 | 10 |
| | | aspect ratio | | 23.0 | 2.0 | 1.2 | 25.0 |
| | | orientation angle (°) | | 48 | 3 | 1.5 | 50 |
| | thickness (µm) | | | 10 | 10 | 10 | 10 |
| electromagnetic wave shielding capability of molding film for electromagnetic wave shields (dB) | | | | 55 | 15 | 55 | 55 |
| electromagnetic wave shielding capability of molding film for electromagnetic wave shields stretched at ratio of 1.6 lengthwise and 1.6 crosswise | | | | 5 | 10 | 15 | 1 |
| moldability of molding film for electromagnetic wave shields | | | | C | A | A | C |

### EXPLANATION OF NUMERALS

1: electrically conductive layer
2: release layer
3: base film
4: molding film for electromagnetic wave shields

## Claims

1. A molding film for electromagnetic wave shields comprising a base film and an electrically conductive layer disposed on at least one side thereof, wherein the electrically conductive layer contains electrically conductive particles A and a thermoplastic resin, the electrically conductive layer having a cross section with a void fraction of 5% or more and 30% or less, and the electrically conductive particles A having an aspect ratio of 5.0 or more and 20.0 or less.

2. A molding film for electromagnetic wave shields as set forth in claim 1, wherein the cross sections of the voids observed in the cross section of the electrically conductive layer have shapes with an aspect ratio of 1.0 or more and 20.0 or less.

3. A molding film for electromagnetic wave shields as set forth in claim 2, wherein the voids have an orientation angle of 0° or more and 45° or less.

4. A molding film for electromagnetic wave shields as set forth in claim 1, wherein the electrically conductive layer contains electrically conductive particles B having an aspect ratio of 1.0 or more and 2.0 or less.

5. A molding film for electromagnetic wave shields as set forth in claim 1, wherein the area of the electrically conductive particles accounts for 50% or more and 90% or less of the cross section of the electrically conductive layer while the area of the thermoplastic resin accounts for 5% or more and 45% or less of the cross section of the electrically conductive layer.

6. A molding film for electromagnetic wave shields as set forth in claim 1, wherein the electrically conductive particles A observed in the cross section of the electrically conductive layer have an orientation angle of 3° or more and 45° or less.

7. A molding film for electromagnetic wave shields as set forth in claim 1, wherein the thickness of the electrically conductive layer is 5 µm or more and 15 µm or less.

8. A molding film for electromagnetic wave shields as set forth in claim 1, wherein a release layer is present between the base film and the electrically conductive layer.
